Europäisches Patentamt

European Patent Office

Office européen des brevets

(11) Publication number: **0 218 406**
**A2**

# EUROPEAN PATENT APPLICATION

(21) Application number: **86307274.0**

(22) Date of filing: **22.09.86**

(51) Int. Cl.⁴: **H 03 L 7/06**
**H 04 N 1/21**

(30) Priority: **01.10.85 JP 218232/85**

(43) Date of publication of application:
**15.04.87 Bulletin 87/16**

(84) Designated Contracting States: **DE FR GB**

(71) Applicant: **SEIKO INSTRUMENTS & ELECTRONICS LTD.**
**31-1, Kameido 6-chome**
**Koto-ku Tokyo 136 (JP)**

(72) Inventor: **Tanaka, Fumihiro Seiko Instruments &**
**Electronics**
**31-1 Kameido 6-chome, Koto-ku**
**Tokyo (JP)**

**Matsushima, Kenichi Seiko Instruments & Electroni**
**31-1 Kameido 6-chome, Koto-ku**
**Tokyo (JP)**

**Shimada, Yoshio Seiko Instruments & Electronics**
**31-1 Kameido 6-chome, Koto-ku**
**Tokyo (JP)**

**Yamaguchi, Kaneo Seiko Instruments & Electronics**
**31-1 Kameido 6-chome, Koto-ku**
**Tokyo (JP)**

**Watanabe, Shinya Seiko Instruments & Electronics**
**31-1 Kameido 6-chome, Koto-ku**
**Tokyo (JP)**

(74) Representative: **Caro, William Egerton et al**
**J. MILLER & CO. Lincoln House 296-302 High Holborn**
**London WC1V 7JH (GB)**

(54) **Sampling clock generation circuit.**

(57) A sampling clock generation circuit comprises a phase comparison circuit (1), a loop filter (2), a voltage control oscillator (3) and a first frequency divider (5). A horizontal sync signal or composite sync signal (8) of the video signal is used as a reference input signal of the phase comparison circuit (1).

FIG.1

**Description**

SAMPLING CLOCK GENERATION CIRCUIT

This invention relates to sampling clock generation circuits. for example for recording apparatus for accurately sampling data of each pixel contained in a video signal.

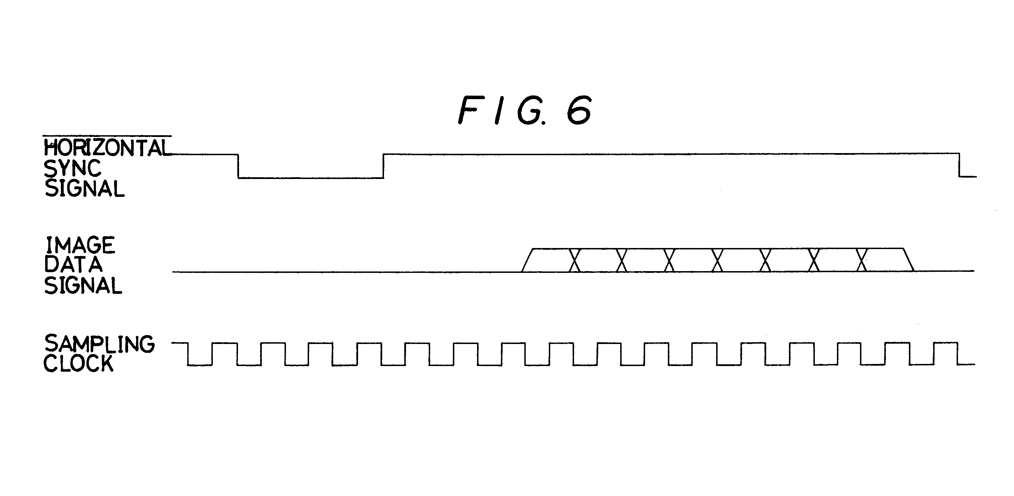

Accuracy and resolution of image display devices in recent CAD/CAM applications have been improved and recording apparatus used for such applications must reproduce the displayed image with a high level of fidelity. In order to attain high fidelity recording, particularly of graphic images using video signals as a medium, sampling by use of a sampling clock on a 1:1 basis must be made for pixel signals. Since the data signal of each pixel is in synchronism with a horizontal signal as shown in Figure 6. the sampling clock must be in synchronism with the horizontal sync signal also. For this reason, the sampling clock in conventional apparatus is generated by providing an oscillation circuit which oscillates at the same frequency as the video signal and controlling only the phase by a PLL circuit using a variable delay circuit with the horizontal signal as the reference.

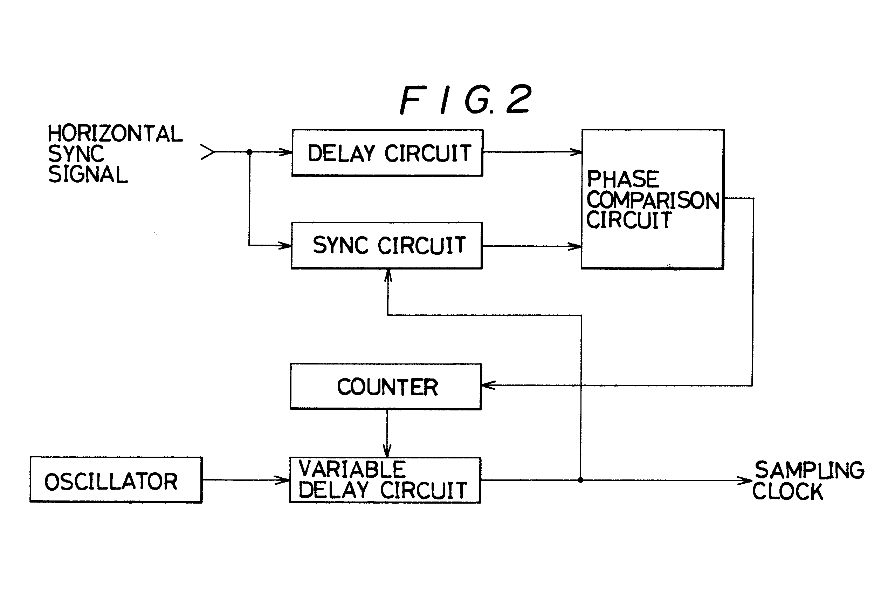

An example of a conventional sampling clock generation circuit will be explained with reference to Figure 2.

The conventional sampling clock generation circuit consists of a portion which compares the phase of a horizontal sync signal synchronised by a sampling clock with that of a delayed horizontal sync signal and detects the phase difference of the sampling clock with respect to the horizontal sync signal, and a portion which controls the phase of the output signal of an oscillator which oscillates at the same frequency as the frequency of a video signal and a variable delay circuit. When the phase advance of the sampling clock is detected, the delay of the variable delay circuit is changed so as to delay the phase of the sampling clock, and when the phase delay of the sampling clock is detected, the delay of the variable delay circuit is changed so as to advance the phase of the sampling clock. In this manner, a clock signal capable of accurately sampling the data of each pixel contained in a video signal is generated by adjusting the phase of the sampling clock to that of the horizontal sync signal as the reference.

When the difference of frequency between the oscillation frequency of the oscillator and the video signal is great, the conventional sampling clock generation circuit cannot control the phase because the phase is deviated within one horizontal period and accurate sampling can no longer be made so that the range of an allowable video signal frequency is narrow and moreover, a high precision oscillator is necessary.

Furthermore, since the variable delay circuit selects output signals having different delays obtained from delay elements and changes the delay, the delay can be controlled only in discrete steps. For this reason. the phase error of the sampling clock is great and high precision delay elements have been necessary.

Hence, the conventional sampling clock generation circuit described above can only be used with a video signal with a frequency of several tens of MHz at most. On the other hand, high resolution and multi-colour image display devices in recent CAD/ CAM applications have to deal with video signal frequencies of over 100 MHz. Accordingly. cost has become a problem on account of the need of higher precision components.

The present invention seeks to provide a sampling clock generation circuit which accurately samples video signals over a wide frequency range.

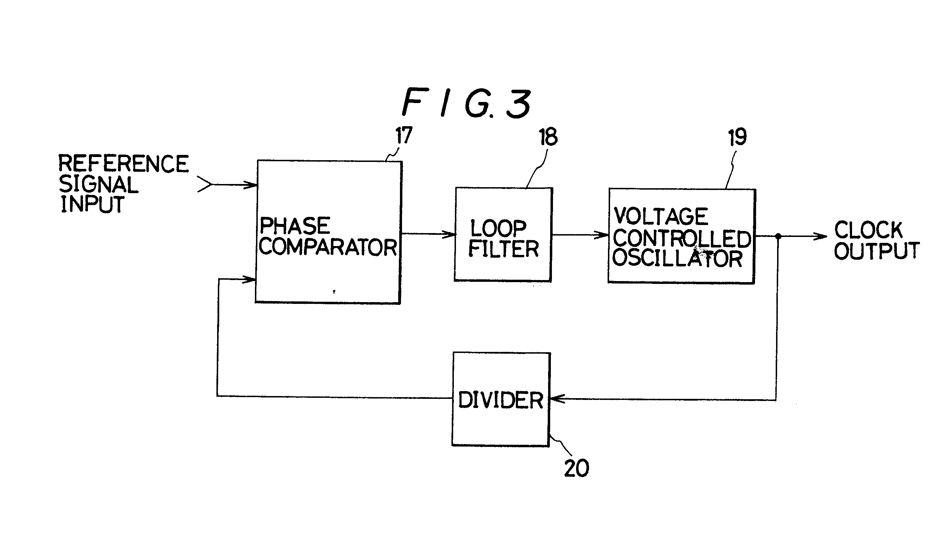

In order to solve problems such as those mentioned above, the present invention may employ a known PLL circuit with a built-in voltage controlled oscillator such as shown in Figure 3 and in U.S. Patent Specification No. 3610954.

According to one aspect of the present invention there is provided a sampling clock generation circuit characterised by comprising: a phase comparison circuit, a loop filter. a voltage controlled oscillator, and a first frequency divider wherein, in operation, a horizontal sync signal or a composite sync signal of a video signal is used as a reference input of said phase comparison circuit.

Preferably the sampling clock generation circuit has a frequency divider with an arbitrary division ratio disposed at the output of said voltage controlled oscillator.

Said second frequency divider may be arranged to produce a sampling clock.

In one embodiment a video signal clock number of one period of said horizontal sync signal or a multiple of said video signal clock number is used as a frequency division ratio of a frequency division circuit comprising said first frequency divider and said second frequency divider.

Said phase comparison circuit may be arranged to effect comparison at the front edge of said horizontal sync signal or a horizontal sync element of said composite sync signal.

The sampling clock generation circuit may include means for inhibiting operation of said phase comparison circuit when a vertical sync element of said composite sync signal of said video signal is inputted.

According to a further aspect of the present invention there is provided a sampling clock generation circuit characterised by comprising a phase comparison circuit having first, second and third terminals, a loop filter connected to an output terminal of said phase comparison circuit, a voltage control oscillator connected to an output terminal of said loop filter for generating a sampling clock to sample a video signal, the second frequency divider connected to an output terminal of said voltage controlled oscillator, and a first frequency divider connected to an output terminal of said second frequency divider and having its output connected to the first input of the phase comparator circuit, said second input terminal of the phase comparator circuit, in operation, receiving a horizontal sync signal or a composite sync signal and receiving a vertical sync signal at said third input terminal thereof.

In the sampling clock generation circuit having the construction described above, a sampling clock having a frequency which is a multiple of the frequency of the horiztonal sync signal by the clock number of the video signal of one horizontal period is generated, the video signal frequency and the frequency of the sampling clock may be in agreement with each other in a wide frequency range and at the same time, the phase of the sampling clock can be in agreement with that of the horizontal sync signal.

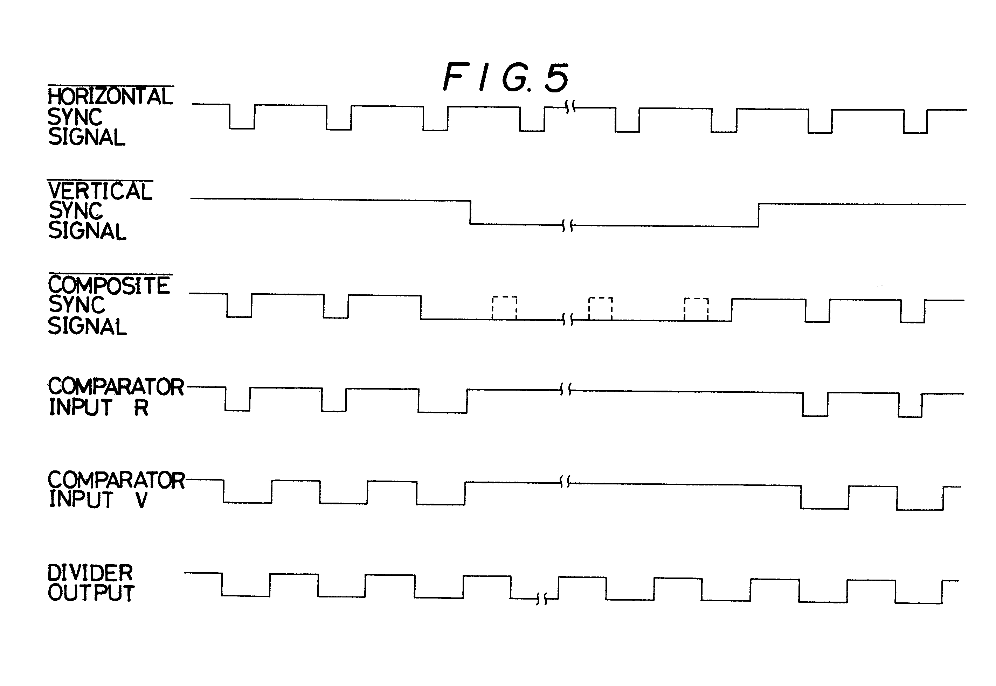

In addition, the operation of the phase comparison circuit is inhibited during the input of the vertical sync signal and phase comparison is made at the front edge of the horizontal sync signal so that even when a composite sync signal of a composite video signal such as shown in Figure 5 is used as the reference input signal, phase detection can be made accurately and the sampling clock to be generated stably.

Furthermore, since the frequency division circuit is disposed at the output of the voltage controlled oscillator, the sampling clock having a frequency which is obtained by frequency-dividing the frequency from the voltage controlled oscillator can be generated and the range of corresponding video signal frequencies can be further expanded.

The invention is illustrated, merely by way of example, in the accompanying drawings, in which:-

Figure 1 is a block diagram of a sampling clock generation circuit according to the present invention;

Figure 2 is a block diagram of a conventional sampling clock generation circuit;

Figure 3 is a block diagram of a PLL circuit used in a sampling clock generation circuit according to the present invention;

Figure 4 is a detailed block diagram of a phase comparison circuit of the sampling clock generation circuit of Figure 1;

Figure 5 is a timing chart of a phase comparison circuit of the sampling clock generation circuit of Figure 1;

Figure 6 is a timing chart of a sampling clock; and

Figure 7 is a circuit block diagram showing a display device and a recording apparatus having a sampling clock generation circuit according to the present invention.

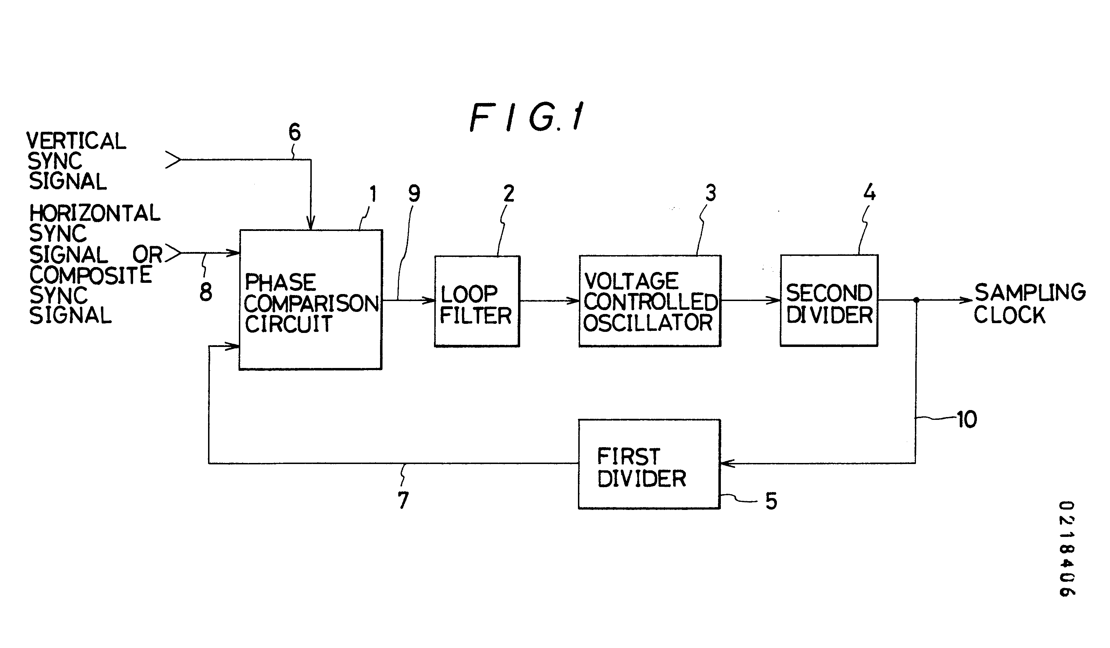

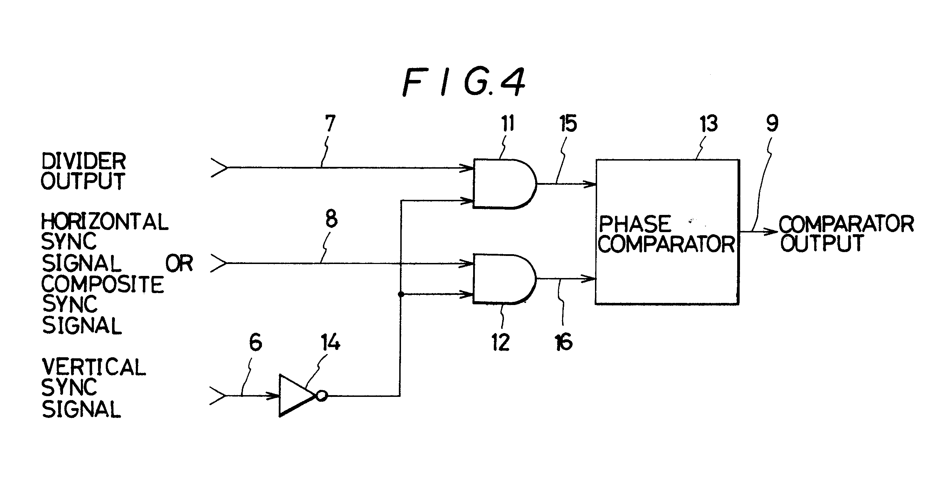

Figure 1 shows a sampling clock generation circuit according to the present invention having a phase comparison circuit 1 constructed such as shown in Figure 4. An input signal to a phase comparator 13 is applied to gates 11,12 and when a vertical sync signal 6 is inputted through an inverter 14, phase comparison is inhibited. This is because composite sync signals of video signals of the composite type vary with display devices, and some are devoid of the horizontal sync signal at the time of input of the vertical sync signal while others have a timing different from an ordinary timing as shown in the timing chart of Figure 5. In such a case a frequency division signal 7 is inhibited and turned into a comparison input signal 15 by the gate 11 while a horizontal sync signal or the composite sync signal 8 is inhibited and turned into a comparison input signal 16 by the gate 12, so that the timing at the front edge of the comparison input signal of the phase comparator 13 is always in agreement with that of the comparison input signal 15 and comparison can be made stably. The phase comparator 13 produces a comparator output 9.

The phase comparator 13 shown in Figure 4 and a loop filter 2 and a voltage controlled oscillator (VCO) 3 shown in Figure 1 are equivalent to the phase comparator 17, loop filter 18 and VCO 19 of a known PLL circuit shown in Figure 3.

A second frequency divider 4 shown in Figure 1 can generate a sampling clock having a frequency lower than that of the oscillation frequency of the VCO 3 by dividing its frequency output. The second frequency divider 4 uses a program counter capable of changing the frequency division ratio in order to expand drastically the range of frequencies of video signals to which it can respond. Though the second frequency divider 4 is shown disposed in the loop of the PLL circuit in Figure 1, it may be disposed outside the loop so that it can divide the frequency of the output of the loop of the PLL circuit at the output of the VCO. Two frequency dividers 4 may also be disposed inside and outside of the loop of the PLL circuit respectively.

A first frequency divider 5 shown in Figure 1 divides the frequency of a sampling clock 10 from the second frequency divider 4 and converts it to a frequency division signal 7 having the same frequency as that of the horizontal sync signal. The first frequency divider 5 uses a programmable counter so as to change the frequency division ratio, and sets the clock number of the video signal of one horizontal period as the frequency division ratio. When the second frequency divider 4 is disposed outside the loop of the PLL circuit, the frequency division ratio of the first frequency divider 5 may be set to the product of the clock number of the video signal of one horizontal period and the frequency division ratio disposed outside the loop.

In the manner described above, the PLL circuit is improved and the sampling clock generation circuit generates the clock signal for sampling the data of each pixel contained in the video signal. Thus, the sampling clock having a frequency which is the product of the frequency of the horizontal sync signal and the clock number of the video signal of one horizontal period and having a phase which is in agreement with that of the horizontal sync signal can be generated not only when the horizontal sync signal of a video signal of the separate type is used as the reference input signal but also when the composite sync signal of a video signal of the composite type is used.

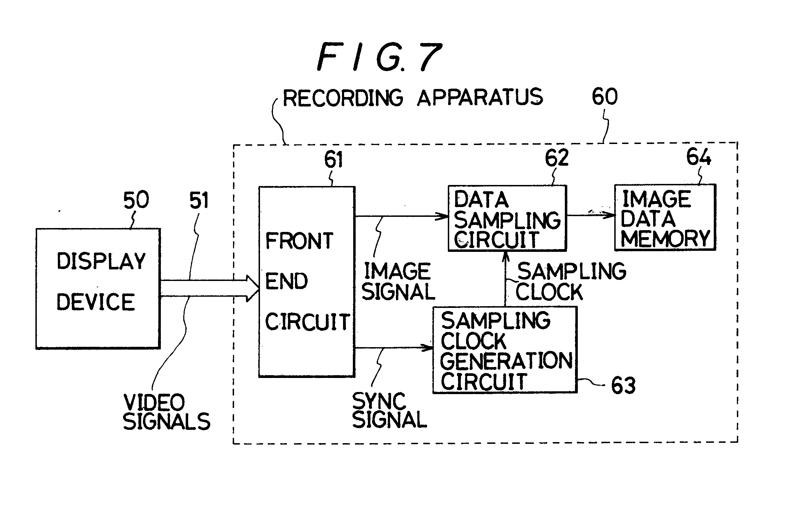

The above mentioned sampling clock generation circuit may be included in a recording apparatus (60) as shown in Figure 7. Video signals 51 from a display device 50 are passed to a front end circuit 61 of the recording apparatus 60. An image signal from the front end circuit is passed to a data sampling circuit 62 and a sync signal from the front end circuit is passed to a sampling clock generation circuit 63 according to the present invention. A sampling clock from the latter is passed to the data sampling circuit 62 whose output is fed to an image data memory 64.

As described above, the sampling clock generation circuit according to the present invention provides the sampling clock for sampling accurately the data of each pixel contained in a separate type or composite type video signal having a wide frequency range. The allowable range of video signal frequencies to which the sampling clock generation circuit can respond can be expanded drastically, the phase error of the sampling clock can be reduced and a high precision oscillator and delay elements become unnecessary.

## Claims

1. A sampling clock generation circuit characterised by comprising: a phase comparison circuit (1), a loop filter (2), a voltage controlled oscillator (3), and a first frequency divider (5) wherein, in operation, a horizontal sync signal or a composite sync signal (8) of a video signal is used as a reference input of said phase comparison circuit (1).

2. A sampling clock generation circuit as claimed in claim 1 characterised by a second frequency divider (4) with an arbitrary division ratio disposed at the output of said voltage controlled oscillator (3).

3. A sampling clock generation circuit as claimed in claim 2 characterised in that said second frequency divider (4) is arranged to produce a sampling clock.

4. A sampling clock generation circuit as claimed in claim 2 or 3. characterised in that a video signal clock number of one period of said horizontal sync signal or a multiple of said video signal clock number is used as a frequency division ratio of a frequency division circuit comprising said first frequency divider (5) and said second frequency divider (4).

5. A sampling clock generation circuit as claimed in any preceding claim characterised in that said phase comparison circuit (1) is arranged to effect comparison at the front edge of said horizontal sync signal or a horizontal sync element of said composite sync signal.

6. A sampling clock generation circuit as claimed in any preceding claim characterised by means (11,12) for inhibiting operation of said phase comparison circuit (1) when a vertical sync element of said composite sync signal of said video signal is inputted.

7. A sampling clock generation circuit characterised by comprising a phase comparison circuit (1) having first, second and third terminals, a loop filter (2) connected to an output terminal of said phase comparison circuit (1), a voltage control oscillator (3) connected to an output terminal of said loop filter (2) for generating a sampling clock to sample a video signal, the second frequency divider (4) connected to an output terminal of said voltage controlled oscillator (3), and a first frequency divider (5) connected to an output terminal of said second frequency divider (4) and having its output connected to the first input of the phase comparator circuit (1), said second input terminal of the phase comparator circuit, in operation, receiving a horizontal sync signal or a composite sync signal (8) and receiving a vertical sync signal (6) at said third input terminal thereof.

8. A recording apparatus characterised by having a sampling clock generation circuit as claimed in any preceding claim.

9. In a recording apparatus (60) for receiving video signals (51) for displaying image data on a display device (50) and recording said image data, a sampling clock generation circuit (63) having a phase comparison circuit (1), a loop filter (2), a voltage controlled oscillator (3) and a first frequency divider (5) wherein a horizontal sync signal or composite sync signal (8) of said video signal is used as a reference input signal of said phase comparison circuit (1).

# FIG.1

VERTICAL SYNC SIGNAL

HORIZONTAL SYNC SIGNAL OR COMPOSITE SYNC SIGNAL

6

8

1 — PHASE COMPARISON CIRCUIT

9

2 — LOOP FILTER

3 — VOLTAGE CONTROLLED OSCILLATOR

4 — SECOND DIVIDER

SAMPLING CLOCK

10

5 — FIRST DIVIDER

7

# F I G. 2

HORIZONTAL SYNC SIGNAL → DELAY CIRCUIT → PHASE COMPARISON CIRCUIT

SYNC CIRCUIT → PHASE COMPARISON CIRCUIT

COUNTER

OSCILLATOR → VARIABLE DELAY CIRCUIT → SAMPLING CLOCK

## F I G. 3

REFERENCE SIGNAL INPUT → PHASE COMPARATOR (17) → LOOP FILTER (18) → VOLTAGE CONTROLLED OSCILLATOR (19) → CLOCK OUTPUT

DIVIDER (20)

# FIG.4

DIVIDER OUTPUT — 7

HORIZONTAL SYNC SIGNAL OR COMPOSITE SYNC SIGNAL — 8

VERTICAL SYNC SIGNAL — 6

14

11 — 15

12 — 16

13 — PHASE COMPARATOR — 9 — COMPARATOR OUTPUT

F I G. 5

HORIZONTAL
SYNC
SIGNAL

VERTICAL
SYNC
SIGNAL

COMPOSITE
SYNC
SIGNAL

COMPARATOR
INPUT R

COMPARATOR
INPUT V

DIVIDER
OUTPUT

0218406

# F I G. 6

HORIZONTAL
SYNC
SIGNAL

IMAGE
DATA
SIGNAL

SAMPLING
CLOCK

# *F I G. 7*

RECORDING APPARATUS    60